# EUROPÄISCHE PATENTANMELDUNG

(11) **EP 1 345 271 A1**
(43) Veröffentlichungstag der Anmeldung: **17.09.2003**
(21) Anmeldenummer: 02005801.2
(22) Anmeldetag: 14.03.2002
(51) Int. Cl.: H01L 27/01, H01L 21/48, H05K 1/16, H01C 17/28

(54) **Verfahren zum Herstellen elektrischer Schaltkreise**

(71) Anmelder: AB Mikroelektronik Gesellschaft m.b.H., 5020 Salzburg (AT)
(72) Erfinder: Wilczek, Klaus-Peter, 83404 Ainring (DE)
(74) Vertreter: Hofinger, Engelbert, Dr.Dr.

(57) **Zusammenfassung**

Verfahren zum Herstellen elektrischer Schaltkreise, welche durch Edelmetalle kontaktierte und über Leiterbahnen aus Kupfer elektrisch verbundene Widerstände (1) und gegebenenfalls Dielektrika umfassen, wobei zumindest die Kontakte (2) der Widerstände aus Edelmetall und die anschließenden Leiterbahnen (4) aus Kupfer durch Aufbringen von Pasten und deren Sintern erzeugt werden, und wobei das Sintern der Leiterbahnen aus Kupfer bei Temperaturen unterhalb 850°C und unterhalb der Temperatur, bei der Kupfer mit dem Edelmetall ein Eutektikum bildet, unter Stickstoffatmosphäre erfolgt, und eine elektrisch leitende Trennschicht (5) zwischen Edelmetallkontakten (2) und Leiterbahn (4) vorgesehen ist.

## Beschreibung

Die Erfindung bezieht sich auf ein Verfahren zum Herstellen elektrischer Schaltkreise, welche durch Edelmetalle kontaktierte und über Leiterbahnen aus Kupfer elektrisch verbundene Widerstände und gegebenenfalls Dielektrika umfassen, wobei zumindest die Kontakte der Widerstände aus Edelmetall und die anschließenden Leiterbahnen aus Kupfer durch Aufbringen von Pasten und deren Sintern erzeugt werden, und wobei das Sintern der Leiterbahnen aus Kupfer bei Temperaturen unterhalb 850°C und unterhalb der Temperatur, bei der Kupfer mit dem Edelmetall ein Eutektikum bildet, unter Stickstoffatmosphäre erfolgt.

Bei einem bekannten Pastensystem erfolgt zuerst das Einbrennen der Widerstände und Dielektrika und der aus einer z.B. AgPt-Legierung bestehenden Unterkreuzungen und Widerstandsanschlüsse bei 850°C an Luft. Sauerstoffzutritt ist für das Sintern von Edelmetallpasten eine wesentliche Voraussetzung. Die für die Bildung der Leiterbahnen benötigte Kupferpaste kann erst nach dem bei Luft erfolgenden Einbrennen der übrigen Komponenten aufgebracht werden, da ihre thermische Härtung unter Stickstoffatmosphäre erfolgen muß.

Die Luft-Standardpasten sind seit vielen Jahren erfolgreich im Gebrauch, es liegen umfangreiche Erfahrungen vor. Die einzelnen Hersteller haben die Systeme Edelmetalleiterbahn/Dielektrika/Widerstände ständig optimiert. Es werden heute alle Eigenschaften hinsichtlich Qualität und Langzeitstabilität erfüllt. Man möchte diese Systeme deshalb beibehalten und kann sie auch aus technischen Gründen nicht mit der Kupfertechnik ersetzen. Man mußte also eine Möglichkeit finden, die Edelmetalltechnik und Kupfertechnik miteinander so zu kombinieren, daß die Eigenschaften der Dielektrika und Widerstände beibehalten werden.

Für die zur Herstellung des Kupferleiters dienende Paste wäre an sich ein Einbrennen unter N₂-Atmosphäre bei 850 - 980°C in Gegenwart von 10 - 20 ppm O₂ in der Brennmuffel zur Erzielung optimaler Haftung erwünscht. Würde man jedoch beim bekannten System derartige Bedingungen anwenden, käme es im Verbindungsbereich von Edelmetallkontakten und Kupferleiter zur Bildung eines eutektischen binären Werkstoffsystems, welches im Fall von CuAg einen Schmelzpunkt von ca. 780°C aufweist. Dies bedeutet, daß man bei den für den Kupferleiter optimalen Brenntemperaturen von 800 - 980°C auf jeden Fall die Liquidustemperatur der Legierung erreichen würde. Beide Metalle würden aufgeschmolzen und lägen ohne Adhäsion zum Substrat als Metallkugeln vor. Eine elektrische Verbindung wäre nicht mehr gesichert bzw. unterbrochen. Um die Bildung eines Eutektikums zu verhindern, wurde daher in EP-A 0 790 644 vorgeschlagen, eine elektrisch leitende Trennschicht zwischen Kupfer und Silber vorzusehen.

Die Erfindung geht im Gegensatz von EP-B 0 790 644 von einem System aus, bei welchem die eutektische Temperatur von 754°C nicht erreicht wird und damit die Trennschicht zwischen Kupfer und Silber überflüssig werden sollte. Beispielsweise wird von der Firma DuPont unter der Bezeichnung MYDAS ein solches System angeboten, bei welchem die Einbrenntemperatur der Kupferpaste zwischen 600 und 650°C liegt.

An sich scheint eine unterhalb von 650°C einbrennbare Kupferpaste ideal zur Lösung des Problems der Verbindung von Edelmetallpaste und Kupfer. Die beste Verbindung des Kupfers zu den keramischen Trägermaterialien wie Al₂O₃ oder AIN erhält man nämlich durch sogenanntes Oxidbonden: Zwischen Cu und O₂ besteht ein binäres, eutektisches System mit einem Schmelzpunkt weit über 1000°C. Da es sich bei diesem Verbindungsprozeß um eine interkristalline Formation handelt, wird eine äußerst hohe und thermisch stabile Haftung erzeugt. Abzugskräfte bis zu 30N/mm² bleiben auch nach Dauertemperaturbeanspruchung von z.B. 1000 Stunden bei 150°C erhalten. Bei Einhaltung aller Trocken- und Brennvorschriften - insbesondere der Gehalt von O₂ während des Brennens - können solche Kupferbahnen auch in Schichtdicken bis 300 µm ohne weitere Veredelung mit Lot benetzt, geschweißt oder mit Aluminiumdraht gebondet werden. Somit sind die üblichen Verbindungstechniken gewährleistet. Die niedrige Temperatur beim Einbrennen der Kupferpaste bedeutet, daß die in Luft eingebrannten Widerstände beim Schutzgasprozeß nur marginal verändert werden, die dielektrischen Strukturen ihre Isolationseigenschaften beibehalten. Somit wäre das Standard-Edelmetallsystem komplett erhalten.

Unerwarteterweise hat sich gezeigt, daß der Einsatz des der Erfindung zugrunde liegenden Pastensystems problematisch ist, wenn die danach hergestellten elektrischen Schaltkreise bei Temperaturen über 100°C verwendet werden. Folgende Erklärung bietet sich an: Die Verbindung des Edelmetalls mit Kupfer erzeugt durch die Spannungsdifferenz von ∼ 0,8 Volt einen Batterieeffekt. Dieses führt unter Temperatur und Feuchte zur Migration von Ag-Material in das Cu, welches die Kristalle des Cu so verändert, daß eine Versprödung der Überlappungszone erfolgt. Die Haftfestigkeit dieser Zone ist nach einigen 100 Stunden thermischer Beanspruchung so geschwächt, daß es zu Leiterbahnunterbrechungen kommen kann. Weiterhin wurde in dieser Zone eine wesentliche Verschlechterung der elektrischen Leitfähigkeit beobachtet, was bei elektronischen Schaltungen - insbesondere beim Einsatz von niederohmigen Halbleitern - zu Funktionsausfällen der Schaltungen führen kann. Durch den Verlust der Haftffestigkeit zum Substrat erwärmt sich die Überlappungszone durch Anlegen eines hohen Stromes derart, daß sie durchbrennt. Dies hat erhebliche Auswirkungen auf die Qualität der elektronischen Schaltungen, was bei Anwendungen im Automobilbereich insbesondere im Bereich des Motors unakzeptabel ist.

Die Erfindung vermeidet die dargestellten Nachteile dadurch, daß jene Trennschicht wieder eingeführt wird, welche durch das Arbeiten unterhalb des eutektischen Punktes gerade vermieden werden sollte. Erfindungsgemäß ist also vorgesehen, daß eine elektrisch leitende Trennschicht zwischen Edelmetallkontakten und Leiterbahn vorgesehen ist.

Die Trennschicht zwischen Kupfer und Silber kann bereits vor der Wärmebehandlung der Kupferpaste aufgebracht werden. Bringt man ein Verbindungsmaterial, welches die elektrische Verbindung und gleichzeitig die räumliche Trennung von Edelmetall und Kupfer herstellen soll, in einen Spalt zwischen Edelmetallkontakt und Kupferleiter ein, so wird die Trennschicht mit dem Kupferleiter beim Erhitzen unter Stickstoffatmosphäre gebrannt.

Die erfindungsgemäß vorgesehene, elektrisch leitende Trennschicht kann auch nach dem Brennen aller übrigen Schaltungsteile erfolgen, indem eine bei niedrigen Temperaturen härtende Leitpaste in den Spalt zwischen Edelmetallkontakt und Kupferleiter aufgebracht wird. Besonders geeignet ist dabei ein Leitkleber aus in Polyimid oder Epoxid verteiltem Silber. Als besonders günstig hat sich als Verbindungsmaterial Lötpaste gezeigt, welche z.B. simultan zum Bestücken mit SMT-Bauteilen auf die Leiterbahnlücke aufgebracht wird. Das Aufschmelzen erfolgt im Reflow-Prozeß.

Durch geeignete Design-Maßnahmen kann auch erreicht werden, daß metallische Teile von Bauteilen als Brückenelement zwischen den Leiterbahnen herangezogen werden.

Einzelheiten der Erfindung werden anschließend anhand der Zeichnung erläutert. In dieser ist
Fig. 1 eine Draufsicht auf ein erstes Ausführungsbeispiel,
Fig. 2 die Draufsicht auf eine durch Edelmetallbahnen gebildete Leiterkreuzung, welche mit Leiterbahnen aus Kupfer kontaktiert wird,
Fig. 3 zeigt eine vergrößerte Seitenansicht des Verbindungsbereiches zwischen Edelmetall und Kupfer,
Fig. 4 die Draufsicht auf eine spezielle geometrische Ausgestaltung des Verbindungsbereiches,
Fig. 5 die Seitenansicht eines Ausführungsbeispieles, bei welchem die Trennschicht teilweise durch einen elektronischen Bauteil gebildet wird.

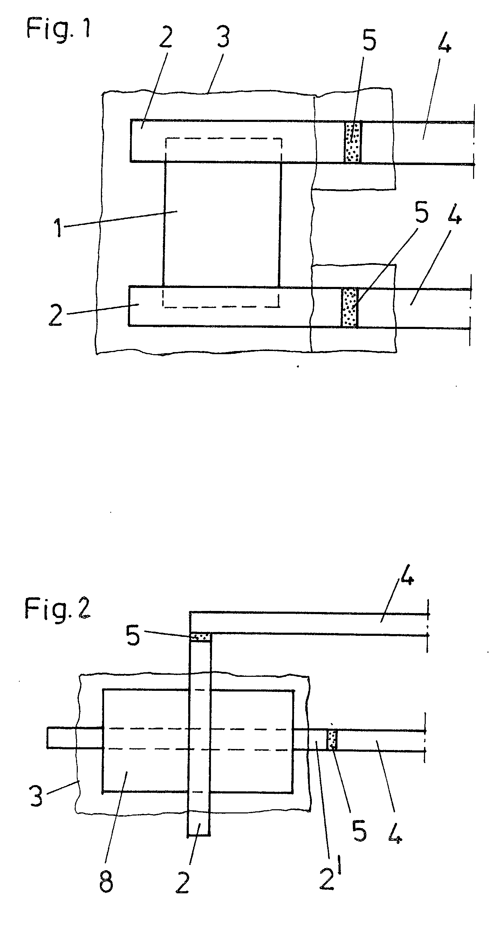

Fig. 1 zeigt einen Ausschnitt aus einem typischen elektrischen Schaltkreis in Hybridtechnik. Gemäß dieser Technik wird ein Substrat aus Keramik nicht nur mit Verbindungsbahnen für vorgefertigte Bauteile bedruckt, mit welchen die Trägerplatte bestückt wird, vielmehr werden zusätzlich zumindest Widerstände ebenfalls direkt auf die Trägerplatte aufgebracht.

Im vorliegenden Fall wird ein Widerstand 1 gebildet, indem eine Paste aufgetragen wird, welche bei 800 - 950°C unter Luft eingebrannt wird. Ein derartiger Widerstand aus den Grundstrukturen Pc/Ag, RuO₂ oder Pyrochlor weist nach dem Sintern hervorragende elektrische werte, wie niedriger Temperaturkoeffizient <50 ppm/K, hohe elektrische Belastbarkeit bis 100 W/mm², extreme Langzeitstabilität der Ohmwerte +/-1% nach 130.000 Stunden Normalbetrieb, sehr guter Abgleichbarkeit der Widerstandswerte mit YAG-Laser bis zu +/- 0,1% Toleranz usw. auf.

Zur Kontaktierung des Widerstandes 1 dienen Kontakte 2 aus Edelmetall. Pasten zur Bildung von Leiterbahnen aus Ag, PdAg, AgPt, AgPdPt, Au, PdAu und ähnlichen Kombinationen für das Einbrennen an Luft bei 800 bis 950°C Brenntemperatur werden angeboten. Die Adhäsion der Pasten wird beim Sintervorgang durch Additive von Glas oder Oxidbildnern hergestellt. Es werden hierbei typische Haftfestigkeiten von 5 - 10 N/mm² erreicht. Alle genannten Pastensysteme sind empfindlich gegen thermische Alterung und zeigen tendenziell eine Verminderung der Haftfestigkeit nach Lagerung z.B. 1000 Stunden bei 150°C von 20 - 50 %. Gold- und silberhaltige Pasten haben zudem den Nachteil, mit den üblichen Weichlotlegierungen z.B. PbSn/PbSnAg eine eutektische Reaktion einzugehen, Silber/Gold löst sich bei Löttemperaturen von 220 - 250°C spontan in Zinn. Im Extremfall kommt es hierbei zum völligen Entnetzen der Paste und somit Ausfall der Schaltung durch Unterbrechungen oder Hochohmigkeit.

Die Verwendung derartiger Pasten zur Kontaktierung der Widerstände und Dielektrika ist trotz der, an sich besseren, Eignung von Kupfer als Leiterbahn notwendig. Nicht alle und vor allem nicht die besten Widerstände und Dielektrika sind nämlich mit Kupfer verträglich.

Zur Bildung der Hybridschaltung werden also zunächst übereinander die Pasten aufgetragen, welche zur Bildung des Widerstandes 1 und der Kontakte 2 dienen. Nach dem Einbrennen aller Drucke gemeinsam bei z.B. 850°C an Luft wird im Siebdruck die Leiterbahn 4 zwischen Kontakt 1 und 2 aufgebracht und bei etwa 600°C gebrannt. Über die Widerstände und Verbindungszonen kann später eine zusätzliche Schutzschicht 3 aus Glas oder Polymer aufgebracht werden.

Der Spalt zwischen Kontakt 2 und Leiterbahn 4 wird mittels einer leitenden Trennschicht 5 geschlossen. Optimale Verbindungen werden dann erzielt, wenn man zur Verbindung die metallischen Anteile wie Anschlußbeine, Bauteilerückseiten oder Kantenmetallisierungen von Bauelementen zusätzlich als solide Brücke integriert.

Fig. 2 zeigt die Verwendung von Edelmetallkontakten 2, 2' zur Bildung einer Leiterkreuzung, welche durch eine dielektrische Trennschicht 8 getrennt ist. Wie anhand von Fig. 1 beschrieben, erfolgt auch hier zunächst das Aufbringen der Bereiche 2, 2', 3 und 8 und deren Einbrennen an Luft. Zwischen den Kontakten 2, 2' und den nach dem Einbrennen an Luft erfolgenden Aufbringen der Kupferpasten zur Bildung der Leiterbahnen 4 verbleibt jedoch zunächst ein Spalt. Erst nach dem Brennen der Kupferpaste unter Stickstoffatmosphäre bei hoher Temperatur wird der Spalt zwischen den Kontakten 2, 2' und den Leiterbahnen 4 durch eine leitende Trennschicht 5 ausgefüllt. Der hierzu dienende Leiterkleber kann aus Kunststoff, wie z.B. Epoxydharz mit darin verteiltem Silber bestehen. Die Aushärtung des Klebers erfolgt bei Raumtemperatur oder bei erhöhter Temperatur und dann so, daß das Kupfer nicht an der Oberfläche oxidiert. Man sollte 130°C nicht überschreiten. Sollte eine höhere Aushärtetemperatur notwendig sein. z.B. Silber in Polyimid, muß die Härtung unter N₂ erfolgen. Anstatt des Leiterklebers kann natürlich auch die Lotverbindung angewendet werden. Die ausgehärteten Leiterschichten können anschließend noch mit einer polymeren Schutzschicht 3 im Siebdruck- oder Dispensverfahren abgedeckt werden.

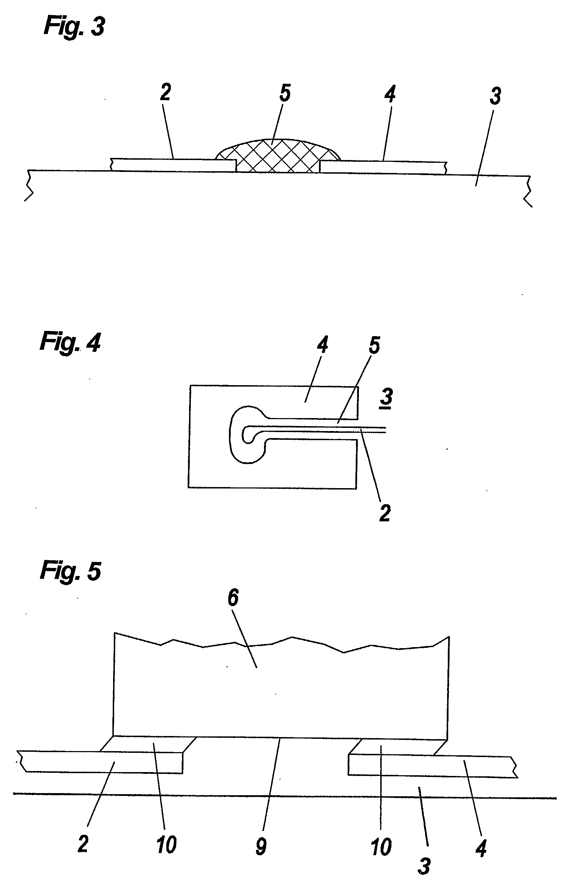

Fig. 3 zeigt die Trennschicht 5 von Fig. 1 in Seitenansicht.

Fig. 4 zeigt, wie die letztlich durch die Trennschicht 5 elektrisch überbrückte Lücke zwischen Edelmetall 2 und aus Kupfer bestehendem Leiter 4 so ausgestaltet werden kann, daß für den Stromübergang eine wenig störanfällige große Fläche entsteht.

Beim Ausführungsbeispiel nach Fig. 5 ist ein großer Abstand zwischen dem Edelmetallkontakt 2 und der Kupferleitung 4 vorgesehen. Dieser wird durch einen elektronischen Bauteil mit leitender Unterseite 9 überbrückt. Die Verbindung zwischen der Unterseite 9 des Bauteils 6 und den gesinterten Pasten 2 und 4 wird durch ein Weichlot gebildet, welches sich mit den Eisen- bzw. Kupferlegierungen der Unterseite 9 gut verbindet. Beispielsweise kann ein solches Weichlot auf der Basis von Zinn oder Blei beruhen.

Mit den beschriebenen Verfahren wird es somit möglich, bisher nicht miteinander kombinierbare Dickschichttechnologien auf einem gemeinsamen Substrat zu realisieren. Dabei bleiben die physikalischen Haupteigenschaften der einzelnen Systeme voll erhalten und ergänzen sich zu einer optimalen technischen Lösung. Die guten physikalischen Eigenschaften und das günstige Ablegierverhalten von Kupferleiterbahnen ermöglichen den Einsatz von höherschmelzenden Lotlegierungen (220°C - 250°C) sowie die Anwendung aller gängigen Verbindungstechnologien wie Löten, Bonden und Schweißen. Deshalb werden insbesondere für die Anwendung bei erhöhten Umgebungstemperaturen, z.B. in der Automobiltechnik, neue Märkte und Anwendungsmöglichkeiten gesehen. Weiterhin ist der Preisvorteil von Cu-Pasten zu sehen.

Ein weiteres Einsatzgebiet ermöglicht die Verwendung von Leiterbahnen aus Kupfer mit selektiv höheren Schichtdicken, bis etwa von 300 µm. Dies ist bei Anwendungen mit erhöhter Verlustleistung wegen des erheblich reduzierten Flächenwiderstandes von großer technischer und kommerzieller Bedeutung.

## Patentansprüche

1. Verfahren zum Herstellen elektrischer Schaltkreise, welche durch Edelmetalle kontaktierte und über Leiterbahnen aus Kupfer elektrisch verbundene Widerstände und gegebenenfalls Dielektrika umfassen, wobei zumindest die Kontakte der Widerstände aus Edelmetall und die anschließenden Leiterbahnen aus Kupfer durch Aufbringen von Pasten und deren Sintern erzeugt werden, und wobei das Sintern der Leiterbahnen aus Kupfer bei Temperaturen unterhalb 850°C und unterhalb der Temperatur, bei der Kupfer mit dem Edelmetall ein Eutektikum bildet, unter Stickstoffatmosphäre erfolgt, **dadurch gekennzeichnet, daß** eine elektrisch leitende Trennschicht zwischen Edelmetallkontakten und Leiterbahn vorgesehen ist.

2. Verfahren nach Anspruch 1, **dadurch gekennzeichnet, daß** die Trennschicht zwischen Edelmetall und Kupfer als Verbindungspaste vor dem Aushärten der Leiterbahn aus Kupfer aufgebracht wird.

3. Verfahren nach Anspruch 1, **dadurch gekennzeichnet, daß** nach der Sinterung zwischen den Kontakten aus Edelmetall und den Leitern aus Kupfer ein Spalt verbleibt, der anschließend durch einen Leitkleber, Lot oder andere leitende Materialien, verschlossen wird, welcher die Trennschicht bildet.

4. Verfahren nach Anspruch 2, **dadurch gekennzeichnet, daß** der Leitkleber im wesentlichen aus in Polyimid verteiltem Silber besteht.

5. Verfahren nach Anspruch 1, **dadurch gekennzeichnet, daß** die metallischen Anschlußkomponenten von Bauteilen die Trennschicht bilden.
